# EUROPEAN PATENT APPLICATION

(11) **EP 4 742 306 A1**
(43) Date of publication of application: **13.05.2026**
(21) Application number: 24856775.2
(22) Date of filing: 19.08.2024
(51) Int. Cl.: H01M 4/04, H01M 10/42, H01M 4/525, H01M 10/052, G01R 19/10, G01R 19/12, G01R 27/26, H01M 4/02

(54) **METHOD FOR ANALYZING CATHODE ACTIVE MATERIAL, CATHODE ACTIVE MATERIAL, CATHODE COMPRISING SAME, AND LITHIUM SECONDARY BATTERY**

(30) Priority: 18.08.2023 KR 20230108534
(71) Applicant: LG Chem, Ltd., Seoul 07336 (KR)
(72) Inventor: JEONG, Myeong Sang, Daejeon 34122 (KR); YOON, Ju Han, Daejeon 34122 (KR); LEE, Seong Nam, Daejeon 34122 (KR); KIM, Won Tae, Daejeon 34122 (KR); LIM, Young Geun, Daejeon 34122 (KR)
(74) Representative: Hoffmann Eitle
(86) International application number: PCT/KR2024/012278
(87) International publication number: WO 2025/042163

(57) **Abstract**

The present invention relates to a method for analyzing a cathode active material, a cathode active material, a cathode and a lithium secondary battery, and, to: a method for analyzing a cathode active material; a cathode active material having a slope, obtained through the analysis method, of 0.00110-0.00130; a cathode comprising same; and a lithium secondary battery, the method comprising the steps of: (S1) preparing a cathode active material that comprises a layer-structured lithium-rich manganese-based oxide, which comprises both a Li₂MnO₃ phase and a LiMO₂ (here, M is an element comprising at least one selected from Ni and Mn) phase, and manufacturing a lithium secondary battery that comprises a cathode comprising a cathode active material layer comprising 80 wt% or more of the cathode active material on the basis of the total weight of the cathode active material layer; (S2) obtaining a specific capacity-voltage graph (x-axis: specific capacity (mAh/g), and y-axis: voltage (V)) by activating the lithium secondary battery at a 0.1C-rate at 45°C ; and (S3) obtaining a slope by linearly fitting, in a section of the graph, data in which a voltage is 4.40-4.65 V.

## Description

### TECHNICAL FIELD

### Cross-reference to Related Applications

The present application claims the benefit of the priority of Korean Patent Application No. 10-2023-0108534, filed on August 18, 2023, which is hereby incorporated by reference in its entirety.

### Technical Field

The present invention relates to a method for analyzing a positive electrode active material, a positive electrode active material, and a positive electrode and a lithium secondary battery which include the same.

### BACKGROUND ART

Lithium secondary batteries are composed of four key components: a positive electrode, a negative electrode, a separator, and an electrolyte. In particular, a positive electrode active material included in the positive electrode is a critical factor in determining the capacity, power output, and lifespan of batteries. To achieve high energy density, power output, and lifespan in lithium secondary batteries, it is essential to improve the performance of the positive electrode active material, and for this reason, extensive research has been conducted lately to develop high-performance positive electrode active materials.

A Li- and Mn-rich layered oxide (LMRO), a type of positive electrode active material, is a mixed phase composed of Li₂MnO₃ and LiMO₂ (M=Ni, Mn, Co) phases, and offers high energy density and enhanced stability, making it suitable as a next-generation positive electrode active material. In addition, the high Mn content in LMRO, a relatively inexpensive element, makes it a more cost-effective option compared to typical high-Ni NCM positive electrode materials.

However, the LMRO undergoes irreversible capacity loss during a first formation process at high voltages, resulting in reduced efficiency compared to NCM-based positive electrode materials, and undergoes structural changes from a layered structure to a spinel structure and eventually to rock-salt structure, resulting in voltage fading and the release of O₂ gas caused by crystal structure degradation. To address these issues, research for achieving enhanced additives or structures is underway, only to fail commercialization yet.

Meanwhile, to evaluate the LMRO capacity characteristics, charge-discharge cycles need to be performed after a cell activation process, making capacity characteristic analysis time-consuming.

Consequently, it is necessary not only to develop an analytical method for predicting the LMRO capacity characteristics but also to develop LMRO exhibiting further improved battery performance.

### DISCLOSURE OF THE INVENTION

### TECHNICAL PROBLEM

A task to be solved in the present invention provides a method for analyzing a positive electrode active material, capable of predicting LMRO capacity characteristics by using a slope obtained from data of a graph obtained from a process of high-temperature activation (45 °C, 0.1 C-rate) of a lithium secondary battery.

In addition, the present invention provides a positive electrode active material in which the slope obtained from the data of a graph obtained through the method for analyzing a positive electrode active material satisfies a specific range.

In addition, the present invention provides a positive electrode and a lithium secondary battery which include the positive electrode active material.

### TECHNICAL SOLUTION

In order to address the tasks described above, the present invention provides a method for analyzing a positive electrode active material, a positive electrode active material, and a positive electrode and a lithium secondary battery which include the same.
(1) The present invention provides a method for analyzing a positive electrode active material, including (S1) preparing a positive electrode active material including a lithium-rich manganese oxide having a layered structure including both a Li2MnO3 phase and a LiMO2 phase (where M is an element including at least one selected from Ni and Mn), and manufacturing a lithium secondary battery including a positive electrode including a positive electrode active material layer including the positive electrode active material in an amount of at least 80 wt% with respect to a total weight of the positive electrode active material layer, (S2) obtaining a specific capacity-voltage graph (X-axis: specific capacity (mAh/g), Y-axis: voltage (V)) obtained by activating the lithium secondary battery at 45 °C with a 0.1 C-rate, and (S3) in the graph, applying linear fitting to data in a voltage range of 4.40 to 4.65 V to obtain a slope.
(2) The present invention provides the method according to (1) above, wherein the lithium-rich manganese oxide exhibits a Li/Me (lithium (Li) to total metals excluding lithium (Me)) molar ratio of greater than 1.00 and 2.00 or less.
(3) The present invention provides the method according to (1) or (2) above, wherein the lithium-rich manganese oxide exhibits a Li/Me (lithium (Li) to total metals excluding lithium (Me)) molar ratio of 1.24 to 1.36.
(4) The present invention provides the method according to any one of (1) to (3) above, wherein the lithium-rich manganese oxide contains at least 50 mol% of Mn with respect to total metals excluding lithium.
(5) The present invention provides the method according to any one of (1) to (4) above, wherein the lithium-rich manganese oxide has a composition represented by Formula 1 below.

   [Formula 1] Li₁₊ₓNiₐMn_{b}M_{c}O₂

   In Formula 1 above,
   M is at least one selected from W, Al, B, Mo, Ti, Co, V, P, Mg, Fe, K, Ca, Na, Y, and Nb, and
   0.10 ≤ x ≤ 0.20, 0 < a ≤ 0.50, 0.50 ≤ b < 1.0, and 0 ≤ c ≤ 0.10.
(6) The present invention provides the method according to any one of (1) to (5) above, wherein the linear fitting involves performing linear regression analysis using weighted least squares in a program of Origin.
(7) The present invention provides a positive electrode active material including a lithium-rich manganese oxide having a layered structure including both a Li₂MnO₃ phase and a LiMO₂ phase (where M is an element including at least one selected from Ni and Mn), wherein in a specific capacity-voltage graph (X-axis: specific capacity (mAh/g), Y-axis: voltage (V)) obtained by activating a lithium secondary battery including a positive electrode including a positive electrode active material layer including the positive electrode active material in an amount of at least 80 wt% with respect to a total weight of the positive electrode active material layer at 45 °C with a 0.1 C-rate, a slope of the graph obtained by applying linear fitting to data in a voltage range of 4.40 to 4.65 V is 0.00115 to 0.00150.
(8) The present invention provides the positive electrode active material according to (7) above, wherein the lithium-rich manganese oxide exhibits a Li/Me (lithium (Li) to total metals excluding lithium (Me)) molar ratio of greater than 1.00 and 2.00 or less.
(9) The present invention provides the positive electrode active material according to (7) or (8) above, wherein the lithium-rich manganese oxide exhibits a Li/Me (lithium (Li) to total metals excluding lithium (Me)) molar ratio of 1.24 to 1.36.
(10) The present invention provides the positive electrode active material according to any one of (7) to (9) above, wherein the lithium-rich manganese oxide contains at least 50 mol% of Mn with respect to total metals excluding lithium.
(11) The present invention provides the positive electrode active material according to any one of (7) to (10) above, wherein the lithium-rich manganese oxide has a composition represented by Formula 1 below.

   [Formula 1] Li₁₊ₓNiₐMn_{b}M_{c}O₂

   In Formula 1 above,
   M is at least one selected from W, Al, B, Mo, Ti, Co, V, P, Mg, Fe, K, Ca, Na, Y, and Nb, and
   0.10 ≤ x ≤ 0.20, 0 < a ≤ 0.50, 0.50 ≤ b < 1.0, and 0 ≤ c ≤ 0.10.
(12) The present invention provides the positive electrode active material according to any one of (7) to (11) above, wherein the lithium-rich manganese oxide has a tap density of 1.5 g/cm³ to 2.5 g/cm³.
(13) The present invention provides the positive electrode active material according to any one of (7) to (12) above, wherein the lithium-rich manganese oxide has an average particle size (D₅₀) of 2.0 µm to 20.0 µm.
(14) The present invention provides a positive electrode including the positive electrode active material according to any one of (7) to (13) above.
(15) The present invention provides a lithium secondary battery including the positive electrode according to (14) above.

### ADVANTAGEOUS EFFECTS

A method for analyzing a positive electrode active material according to the present invention may predict LMRO capacity characteristics by using a slope obtained from data of a graph obtained from a process of high-temperature activation (45 °C, 0.1 C-rate) of a lithium secondary battery. Accordingly, the time for analyzing performance of the positive electrode active material may be reduced.

A positive electrode active material according to the present invention may include a lithium-rich manganese oxide, and in a specific capacity-voltage graph (X-axis: specific capacity (mAh/g), Y-axis: voltage (V)) obtained by activating a lithium secondary battery including the positive electrode active material at 45 °C with a 0.1 C-rate, a slope of the graph obtained by applying linear fitting to data in a voltage range of 4.40 to 4.65 V satisfies a specific range, and accordingly, batteries may exhibit excellent performance, particularly excellent discharge capacity characteristics.

A positive electrode and a lithium secondary battery according to the present invention may exhibit excellent discharge capacity characteristics.

### BRIEF DESCRIPTION OF THE DRAWINGS

FIG. 1 is a specific capacity-voltage graph (X-axis: specific capacity (mAh/g), Y-axis: voltage (V)) obtained when evaluating a battery including a positive electrode active material of Example 1 as in Experimental Example 1; and
FIG. 2 is a view showing a slope of a graph obtained by applying linear fitting to data in a voltage range of 4.40 to 4.65 V through a program of Origin, from the graph of FIG. 1.

### BEST MODE FOR CARRYING OUT THE INVENTION

Hereinafter, the present invention will be described in detail to aid in understanding of the present invention.

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

It will be further understood that the term "include", "comprise", or "have" used herein, specifies the presence of stated features, numbers, steps, elements, or combinations thereof, but does not preclude the presence or addition of one or more other features, numbers, steps, elements, or combinations thereof.

Herein, a tap density, indicating an apparent density of powder, obtained by charging 10 g of powder in an about 20 cc container and vibrating the container 3,000 times, may be measured using a typical tap density meter (e.g., GEOPYC-1360 from Micromeritics).

Herein, an average particle size D₅₀ may be defined as a particle size at a cumulative volume distribution of 50% in a particle size distribution curve (curve on the graph of a particle size distribution) of each particle. After dispersing measurement target powder in a dispersion medium, the dispersion medium is introduced into a commercial laser diffraction particle size measurement instrument (e.g., S3500 from Microtrac), a particle size distribution is calculated by measuring a difference in diffraction patterns due to a particle size when particles pass through a laser beam, and the D₅₀ may be obtained by calculating a particle diameter at 50% of the cumulative distribution of volume according to the particle diameter using the measurement instrument.

Herein, a 'primary particle' indicates a smallest unit of particles recognized when observing a positive electrode active material through a scanning electron microscope (SEM), and a 'secondary particle' indicates a secondary structure where a plurality of primary particles are aggregated.

### Method for analyzing positive electrode active material

The present invention provides a method for analyzing a positive electrode active material, including (S1) preparing a positive electrode active material including a lithium-rich manganese oxide having a layered structure including both a Li₂MnO₃ phase and a LiMO₂ phase (where M is an element including at least one selected from Ni and Mn), and manufacturing a lithium secondary battery including a positive electrode including a positive electrode active material layer including the positive electrode active material in an amount of at least 80 wt% with respect to a total weight of the positive electrode active material layer, (S2) obtaining a specific capacity-voltage graph (X-axis: specific capacity (mAh/g), Y-axis: voltage (V)) obtained by activating the lithium secondary battery at 45 °C with a 0.1 C-rate, and (S3) in the graph, applying linear fitting to data in a voltage range of 4.40 to 4.65 V to obtain a slope.

The inventors of the present invention have found that, in the analysis of lithium-rich manganese oxide, when a slope value of a graph derived during a process of high-temperature activation (45 °C, 0.1 C-rate) is used as an evaluation criterion for a positive electrode active material along with XRD, powder characteristics, and the like, more accurate and faster analysis may be performed and reliability may be further increased, thereby completing the present invention. Specifically, the inventors of the present invention have found that when a slope obtained in step (S3) of the method for analyzing a positive electrode active material according to the present invention is 0.00115 to 0.00150, discharge capacity is as high as 190 mAh/g or greater at a 0.33 C-rate. In conclusion, it is seen that according to the method for analyzing a positive electrode active material of the present invention, discharge performance at a 0.33 C-rate may be predicted in advance simply through the process of high-temperature activation (45 °C, 0.1 C-rate) of a lithium secondary battery, and thus the time for evaluating and analyzing a positive electrode active material may be reduced.

Hereinafter, each step of the method for analyzing a positive electrode active material according to the present invention will be described in more detail.

### Step (S1)

Step (S1) involves preparing a positive electrode active material comprising a lithium-rich manganese oxide having a layered structure comprising both a Li₂MnO₃ phase and a LiMO₂ phase (where M is an element comprising at least one selected from Ni and Mn), and manufacturing a lithium secondary battery comprising a positive electrode comprising a positive electrode active material layer comprising the positive electrode active material in an amount of at least 80 wt% with respect to a total weight of the positive electrode active material layer;

According to the present invention, the lithium-rich manganese oxide may exhibit a Li/Me (lithium (Li) to total metals excluding lithium (Me)) molar ratio of greater than 1.00 and 2.00 or less. Specifically, the lithium-rich manganese oxide may exhibit a Li/Me (lithium (Li) to total metals excluding lithium (Me)) molar ratio of 1.24 or greater, 1.26 or greater, 1.28 or greater, 1.32 or less, 1.34 or less, or 1.36 or less.

According to the present invention, the lithium-rich manganese oxide may have an Mn content of 50 mol% or greater, specifically 60 mol% or greater, and more specifically 65 mol% or greater, with respect to total metals excluding lithium.

According to the present invention, the lithium-rich manganese oxide may have a composition represented by Formula 1 below.

[Formula 1] Li₁₊ₓNiₐMn_{b}M_{c}O₂

In Formula 1 above,
M is at least one selected from W, Al, B, Mo, Ti, Co, V, P, Mg, Fe, K, Ca, Na, Y, and Nb, and
0.10 ≤ x ≤ 0.20, 0 < a ≤ 0.50, 0.50 ≤ b < 1.0, and 0 ≤ c ≤ 0.10.

Specifically, x above may be 0.10 or greater, 0.11 or greater, 0.12 or greater, or 0.13 or greater, and may be 0.15 or less, 0.16 or less, 0.17 or less, 0.18 or less, 0.19 or less, or 0.20 or less.

Specifically, a above may be greater than 0, 0.10 or greater, 0.15 or greater, 0.20 or greater, or 0.25 or greater, and may be 0.35 or less, 0.40 or less, 0.45 or less, or 0.50 or less.

Specifically, b above may be 0.50 or greater or 0.55 or greater, and may be 0.65 or less, 0.70 or less, 0.75 or less, 0.80 or less, 0.95 or less, or less than 1.0.

Specifically, c above may be 0 or greater, and may be 0.05 or less, or 0.10 or less.

The lithium-rich manganese oxide may not contain costly cobalt.

The lithium-rich manganese oxide may be doped with tungsten.

The positive electrode may be prepared according to a typical method of preparing a positive electrode, except that the positive electrode active material described above is used. Specifically, the positive electrode may be prepared by applying a composition for forming a positive electrode active material layer, which is prepared by dissolving or dispersing the positive electrode active material and, if required, a binder, a conductive material, and optionally a dispersant in a solvent, onto a positive electrode current collector, followed by drying and rolling, or may be prepared by casting a separate support with the composition for forming a positive electrode active material layer and then laminating a film separated from the support on the positive electrode current collector. In this case, the drying may be performed at a temperature of 100 °C to 150 °C. In addition, the rolling may be performed such that the positive electrode has a porosity of 20 to 30%. That is, the porosity of the prepared positive electrode may be 20 to 30%.

In addition, the positive electrode active material may be included in an amount of 80 wt% or greater, specifically 80 wt% to 99 wt%, and more specifically 85 wt% to 98.5 wt% with respect to a total weight of the positive electrode active material layer.

In addition, the binder may be included in an amount of greater than 0 wt% and 15 wt% or less, specifically greater than 0 wt% and 10 wt% or less, and more specifically 0.1 wt% to 10 wt%, with respect to a total weight of the positive electrode active material layer.

In addition, the conductive material may be included in an amount of greater than 0 wt% and 15 wt% or less, specifically greater than 0 wt% and 10 wt% or less, and more specifically 0.1 wt% to 10 wt%, with respect to a total weight of the positive electrode active material layer.

The lithium secondary battery may be manufactured according to a typical method for manufacturing a lithium secondary battery. For example, the above lithium secondary battery may be manufactured by placing a separator between a positive electrode and a negative electrode to prepare an electrode assembly, positioning the electrode assembly inside a battery case, and injecting an electrolyte, but the embodiment of the present invention is not limited thereto.

### Step (S2)

Step (S2) involves obtaining a specific capacity-voltage graph (X-axis: specific capacity (mAh/g), Y-axis: voltage (V)) obtained by activating the lithium secondary battery at 45 °C with a 0.1 C-rate.

### Step (S3)

Step (S3) involves obtaining a slope by applying linear fitting to data in a voltage range of 4.40 to 4.65 V in the graph described above.

The linear fitting may involve performing linear regression analysis using weighted least squares in a program of Origin. That is, the slope of the graph obtained through linear fitting may be a value analyzed by performing linear regression analysis using weighted least squares in a program of Origin.

### Positive electrode active material

The present invention provides a positive electrode active material including a lithium-rich manganese oxide having a layered structure including both a Li₂MnO₃ phase and a LiMO₂ phase (where M is an element including at least one selected from Ni and Mn), wherein in a specific capacity-voltage graph (X-axis: specific capacity (mAh/g), Y-axis: voltage (V)) obtained by activating a lithium secondary battery including a positive electrode including a positive electrode active material layer including the positive electrode active material in an amount of at least 80 wt% with respect to a total weight of the positive electrode active material layer at 45 °C with a 0.1 C-rate, a slope of the graph obtained by applying linear fitting to data in a voltage range of 4.40 to 4.65 V is 0.00115 to 0.00150.

The inventors of the present invention found that when a positive electrode active material included a lithium-rich manganese oxide, and in a specific capacity-voltage graph (X-axis: specific capacity (mAh/g), Y-axis: voltage (V)) obtained by activating a lithium secondary battery including the positive electrode active material at 45 °C with a 0.1 C-rate, a slope of the graph obtained by applying linear fitting to data in a voltage range of 4.40 to 4.65 V satisfied a specific range, batteries including the positive electrode active material were superior in discharge capacity, particularly in discharge capacity at a 0.33 C-rate, thereby completing the invention.

Meanwhile, in a specific capacity-voltage graph (X-axis: specific capacity (mAh/g), Y-axis: voltage (V)) obtained by activating a lithium secondary battery including the positive electrode active material at 45 °C with a 0.1 C-rate, when a slope of the graph obtained by applying linear fitting to data in a voltage range of 4.40 to 4.65 V was outside a range of 0.00115 to 0.00150, batteries exhibited degraded performance.

According to the present invention, the lithium-rich manganese oxide may exhibit a Li/Me (lithium (Li) to total metals excluding lithium (Me)) molar ratio of greater than 1.00 and 2.00 or less. Specifically, the lithium-rich manganese oxide may exhibit a Li/Me (lithium (Li) to total metals excluding lithium (Me)) molar ratio of 1.24 or greater, 1.26 or greater, 1.28 or greater, 1.32 or less, 1.34 or less, or 1.36 or less. In this case, a battery including the positive electrode active material according to the present invention may achieve a certain level of initial charging capacity at high temperature and improved charge/discharge efficiency. In addition, when evaluating the lifespan characteristics of the battery, an amount of oxygen gas generated due to structural degradation may also be reduced.

According to the present invention, the lithium-rich manganese oxide may have an Mn content of 50 mol% or greater, specifically 60 mol% or greater, and more specifically 65 mol% or greater, with respect to total metals excluding lithium. In this case, high capacity may be achieved even under high voltage charging conditions.

According to the present invention, the lithium-rich manganese oxide may have a composition represented by Formula 1 below. In this case, the lithium-rich manganese oxide has the benefits of high energy density and low cost. In addition, the lithium-rich manganese oxide is more stable than NCM-based positive electrode active materials, thereby reducing the risk of explosion in lithium secondary batteries.

[Formula 1] Li₁₊ₓNiₐMn_{b}M_{c}O₂

In Formula 1 above,
M is at least one selected from W, Al, B, Mo, Ti, Co, V, P, Mg, Fe, K, Ca, Na, Y, and Nb, and
0.10 ≤ x ≤ 0.20, 0 < a ≤ 0.50, 0.50 ≤ b < 1.0, and 0 ≤ c ≤ 0.10.

Specifically, x above may be 0.10 or greater, 0.11 or greater, 0.12 or greater, or 0.13 or greater, and may be 0.15 or less, 0.16 or less, 0.17 or less, 0.18 or less, 0.19 or less, or 0.20 or less.

Specifically, a above may be greater than 0, 0.10 or greater, 0.15 or greater, 0.20 or greater, or 0.25 or greater, and may be 0.35 or less, 0.40 or less, 0.45 or less, or 0.50 or less.

Specifically, b above may be 0.50 or greater or 0.55 or greater, and may be 0.65 or less, 0.70 or less, 0.75 or less, 0.80 or less, 0.95 or less, or less than 1.0.

Specifically, c above may be 0 or greater, and may be 0.05 or less, or 0.10 or less.

The lithium-rich manganese oxide may not contain costly cobalt, and may improve the performance of lithium secondary batteries without cobalt.

The lithium-rich manganese oxide may be doped with tungsten. Tungsten is superior to manganese in stability and electrical conductivity, and accordingly, when the lithium-rich manganese oxide is doped with tungsten, lithium secondary batteries may have further improved performance and stability.

According to the present invention, the lithium-rich manganese oxide may have a tap density of 1.5 g/cm³ or greater, 1.6 g/cm³ or greater, 1.7 g/cm³ or greater, or 1.8 g/cm³ or greater, 2.2 g/cm³ or less, 2.3 g/cm³ or less, or 2.5 g/cm3 or less. When the tap density is within the above range, an electrode has increased packing density, and may thus achieve high-capacity characteristics and improved cost-effectiveness.

According to the present invention, the lithium-rich manganese oxide may have an average particle size (D₅₀) of 2.0 µm or greater, 2.5 µm or greater, or 3.0 µm or greater, and may have an average particle size (D₅₀) of 15.0 µm or less, or 20.0 µm or less. When the average particle size (D₅₀) of the lithium-rich manganese oxide is within the above range, electrode rolling is achieved without breaking particles of the positive electrode active material, resulting in enhanced capacity characteristics.

The positive electrode active material according to the present invention may be prepared by dry mixing a composite transition metal hydroxide and a lithium-containing raw material, and then firing the mixture. In the dry mixing of the composite transition metal hydroxide and the lithium-containing raw material, a doping element-containing raw material may be further mixed. That is, the doping element-containing raw material may be optionally added.

The positive electrode active material according to the present invention may be prepared by optimizing conditions such as the composition of the composite transition metal hydroxide, the mixing amount of the composite transition metal hydroxide and the lithium-containing raw material, the addition of the doping element-containing raw material, and firing temperature and time.

The composite transition metal hydroxide may be prepared through a typically known coprecipitation method, and may have a composition represented by Formula 2.

[Formula 2] NiₚMn_{q}M'ᵣ(OH)₂

In Formula 2 above,
M' is at least one selected from Co, W, Al, B, Mo, Ti, Co, V, P, Mg, Fe, K, Ca, Na, Y, and Nb, and
0<p≤0.50, 0.50≤q<1.0, and 0≤r≤0.10.

Specifically, p above may be greater than 0, 0.10 or greater, 0.15 or greater, 0.20 or greater, or 0.25 or greater, and may be 0.35 or less, 0.40 or less, 0.45 or less, or 0.50 or less.

Specifically, q above may be 0.50 or greater, 0.55 or greater, 0.60 or greater, or 0.65 or greater, and may be 0.65 or less, 0.70 or less, 0.75 or less, 0.80 or less, 0.95 or less, or less than 1.0.

Specifically, r above may be 0 or greater, and may be 0.05 or less, or 0.10 or less.

The composite transition metal hydroxide may not contain costly cobalt, and may improve the performance of lithium secondary batteries without cobalt.

The lithium-containing raw material is a lithium-containing raw material that may be used in the preparation of a positive electrode active material, and may be, for example, lithium hydroxide, lithium carbonate, or lithium oxide.

The doping element-containing raw material, a compound containing at least one selected from Co, W, Al, B, Mo, Ti, Co, V, P, Mg, Fe, K, Ca, Na, Y, and Nb, may be tungsten oxide when a doping element is W, and may be molybdenum oxide, ammonium molybdate, lithium molybdate, and the like when a doping element is Mo.

The composite transition metal hydroxide, the lithium-containing raw material, and the doping element-containing raw material may be added in an amount such that the resulting lithium-rich manganese oxide has a composition represented by Formula 1 above.

The composite transition metal hydroxide and the lithium-containing raw material may be mixed in an amount such that a molar ratio of total metals in the complex transition metal hydroxide to lithium in the lithium-containing raw material is greater than 1.00 and 2.00 or less, specifically, 1.24 to 1.36, 1.26 to 1.36, or 1.28 to 1.34.

The mixing of the composite transition metal hydroxide and the lithium-containing raw material may involve dry mixing, and may be performed using a blade mixer or an acoustic mixer.

The doping element-containing raw material may be mixed in an amount of 5,000 ppm to 20,000 ppm with respect to a total weight of the composite transition metal hydroxide and the lithium-containing raw material.

The firing may be performed at a temperature of 600 °C to 1,000 °C, specifically 880 °C to 940 °C, for a duration of 5 to 30 hours, more specifically 9 to 21 hours, to enhance preparation of the positive electrode active material (reaction of raw materials) and crystallinity of the positive electrode active material.

The firing may be performed in an air atmosphere or an oxygen atmosphere to improve the reactivity of reaction raw materials.

### Positive electrode

The present invention provides a positive electrode including the positive electrode active material according to the present invention.

The positive electrode may include a positive electrode current collector and a positive electrode active material layer formed on the positive electrode current collector, and the positive electrode active material layer may include the above positive electrode active material.

The positive electrode current collector may include a highly conductive metal and is not particularly limited as long as the positive electrode active material layer easily adheres thereto and the positive electrode current collector has no reactivity in the voltage range of a battery. As the positive electrode current collector, for example, stainless steel, aluminum, nickel, titanium, fired carbon, or aluminum or stainless steel that is surface-treated with one of carbon, nickel, titanium, silver, or the like may be used. In addition, the positive electrode current collector may typically have a thickness of 3 µm to 500 µm, specifically 3 µm to 50 µm, and more specifically 10 µm to 30 µm, and fine irregularities may be formed on a surface of the current collector to improve the adhesion of the positive electrode active material. For example, the positive electrode current collector may be used in various forms such as a film, a sheet, a foil, a net, a porous body, a foam body, and a non-woven fabric body.

The positive electrode active material layer may optionally include a conductive material and a binder in addition to the positive electrode active material, as necessary. In this case, the positive electrode active material may be included in an amount of 80 wt% or greater, specifically 80 wt% to 99 wt%, and more specifically 85 wt% to 98.5 wt% with respect to a total weight of the positive electrode active material layer, and excellent capacity properties may be obtained within this range.

The conductive material is used to impart conductivity to an electrode, and any conductive material may be used without particular limitation as long as it has electron conductivity without causing a chemical change in a battery to be constituted. Specific examples thereof may include graphite such as natural graphite or artificial graphite; a carbon-based material such as carbon black, acetylene black, Ketjen black, channel black, furnace black, lamp black, thermal black, and carbon fibers; metal powder or metal fiber such as copper, nickel, aluminum, and silver; conductive tubes such as carbon nanotubes; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be included in an amount of greater than 0 wt% and 15 wt% or less, specifically greater than 0 wt% and 10 wt% or less, and more specifically 0.1 wt% to 10 wt%, with respect to a total weight of the positive electrode active material layer.

The binder serves to improve the bonding between positive electrode active material particles and the adhesion between the positive electrode active material and the current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, polymethymethaxrylate, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated EPDM, styrene-butadiene rubber (SBR), fluorine rubber, polyacrylic acid, and a polymer obtained by substituting hydrogen of the above materials with Li, Na, or Ca, or various copolymers, and any one thereof or a mixture of two or more thereof may be used. The binder may be included in an amount of greater than 0 wt% and 15 wt% or less, specifically greater than 0 wt% and 10 wt% or less, and more specifically 0.1 wt% to 10 wt%, with respect to a total weight of the positive electrode active material layer.

The positive electrode may be prepared according to a typical method of preparing a positive electrode, except that the positive electrode active material described above is used. Specifically, a composition for forming a positive electrode active material layer, which is prepared by dissolving or dispersing the positive electrode active material as well as optionally the binder and the conductive agent in a solvent, is coated on the positive electrode current collector, and the positive electrode may then be prepared by drying and rolling the coated positive electrode current collector, or the positive electrode may be prepared by casting the composition for forming a positive electrode active material layer on a separate support and then laminating a film separated from the support on the positive electrode current collector. In this case, the drying may be performed at a temperature of 100 °C to 150 °C. In addition, the rolling may be performed such that the positive electrode has a porosity of 20 to 30%. That is, the porosity of the prepared positive electrode may be 20 to 30%.

The solvent may be a solvent commonly used in the art, and may be dimethyl sulfoxide (DMSO), isopropyl alcohol, N-methylpyrrolidone (NMP), dimethylformamide (DMF), acetone, water, or the like, and any one thereof or a mixture of two or more thereof may be used. The amount of the solvent to be used is sufficient if the solvent may dissolve or disperse the positive electrode active material, the conductive material, the binder, and the dispersant in consideration of the applying thickness of the slurry and preparation yield, and thereafter, have a viscosity which may exhibit excellent thickness uniformity upon application for the preparation of the positive electrode.

### Lithium secondary battery

The present invention provides a lithium secondary battery including the positive electrode described above.

The lithium secondary battery may include the positive electrode, a negative electrode, a separator interposed between the positive electrode and the negative electrode, and an electrolyte. In addition, the lithium secondary battery may selectively further include a battery case for accommodating an electrode assembly composed of the positive electrode, the negative electrode, and the separator, and a sealing member for sealing the battery case.

The negative electrode may include a negative electrode current collector, and a negative electrode active material layer disposed on the negative electrode current collector.

The negative electrode current collector is not particularly limited as long as it has a high conductivity without causing a chemical change in a battery. For example, copper, stainless steel, aluminum, nickel, titanium, baked carbon, copper or stainless steel that is surface-treated with one of carbon, nickel, titanium, silver, and the like, an aluminum-cadmium alloy, and the like may be used. In addition, the negative electrode current collector may typically have a thickness of 3 µm to 500 µm, and as in the case of the positive electrode current collector, fine irregularities may be formed on a surface of the negative electrode current collector to improve the adhesion of the negative electrode active material. The negative electrode current collector, for example, may be used in various shapes such as that of a film, a sheet, a foil, a net, a porous body, a foam body, a non-woven fabric body, and the like.

The negative electrode active material layer may optionally include a binder and a conductive material in addition to the negative electrode active material.

A compound capable of reversibly intercalating and deintercalating lithium may be used as the negative electrode active material. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as SiO_{β}(0<β<2), SnO₂, a vanadium oxide, and a lithium vanadium oxide; or a composite including the metallic compound and the carbonaceous material such as an Si-C composite or an Sn-C composite, and any one thereof or a mixture of two or more thereof may be used. In addition, as the negative electrode active material, a lithium metal thin film may be used. Furthermore, both low crystalline carbon and high crystalline carbon may be used as the carbon material. Typical examples of the low-crystalline carbon may be soft carbon and hard carbon, and typical examples of the high-crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature fired carbon such as petroleum or coal tar pitch derived cokes. The negative electrode active material may be included in an amount of 80 wt% to 99 wt% with respect to a total weight of the negative electrode active material layer.

The binder of the negative electrode active material layer is a component that assists in the binding between the conductive agent, the active material, and the current collector, and is commonly added in an amount of 0.1 wt% to 10 wt% with respect to the total weight of the negative electrode active material layer. Examples of the binder may be polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene polymer (EPDM), a sulfonated-EPDM, a styrene-butadiene rubber, a nitrile-butadiene rubber, a fluorine rubber, and various copolymers thereof.

The conductive material of the negative electrode active material layer is a component for further improving the conductivity of a negative electrode active material, and may be added in an amount of 10 wt% or less, preferably 5 wt% or less, with respect to the total weight of a negative electrode active material layer. Such conductive material is not particularly limited as long as it has conductivity without causing chemical changes in the battery, and for example, a conductive material, such as: graphite such as natural graphite and artificial graphite; carbon black such as acetylene black, Ketjen black, channel black, furnace black, lamp black, and thermal black; conductive fibers such as carbon fibers and metal fibers; metal powder such as carbon fluoride powder, aluminum powder, and nickel powder; conductive whiskers such as zinc oxide whiskers and potassium titanate whiskers; conductive metal oxide such as titanium oxide; or polyphenylene derivatives, or the like may be used.

The negative electrode may be prepared by applying a composition for forming a negative electrode active material layer, which is prepared by dissolving or dispersing a negative electrode active material and optionally a binder and a conductive material in a solvent, on a negative electrode current collector, followed by drying, or may be prepared by casting a composition for forming a negative electrode active material layer on a separate support and then laminating a film separated from the support on the negative electrode current collector.

The separator separates the negative electrode and the positive electrode and provides a movement path of lithium ions, and any separator may be used as the separator without particular limitation as long as it is typically used in secondary batteries, and particularly, a separator having excellent moisture-retention of an electrolyte as well as low resistance to ion movement in the electrolyte is preferable. Specifically, a porous polymer film, for example, a porous polymer film prepared using a polyolefin-based polymer such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a typical porous nonwoven fabric, for example, a nonwoven fabric formed of high melting point glass fibers or polyethylene terephthalate fibers may be used. Furthermore, a coated separator including a ceramic component or a polymer material may be used to secure heat resistance or mechanical strength, and the separator having a single layer or multilayer structure may be optionally used.

As the electrolyte, an organic liquid electrolyte, an inorganic liquid electrolyte, a solid polymer electrolyte, a gel-type polymer electrolyte, an inorganic solid electrolyte, a molten-type inorganic electrolyte, or the like that is usable in the manufacture of a lithium secondary battery may be used without particular limitation. As a specific example, the electrolyte may include an organic solvent and a lithium salt.

Any organic solvent may be used without particular limitation as long as it may serve as a medium through which ions involved in an electrochemical reaction of a battery may move. Specifically, an ester-based solvent such as methyl acetate, ethyl acetate, γ-butyrolactone, and ε-caprolactone; an ether-based solvent such as dibutyl ether or tetrahydrofuran; a ketone-based solvent such as cyclohexanone; an aromatic hydrocarbon-based solvent such as benzene and fluorobenzene; or a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond aromatic ring or ether bond); amides such as dimethylformamide; dioxolanes such as 1,3-dioxolane; or sulfolanes may be used as the organic solvent. Among these solvents, the carbonate-based solvent is preferable, and a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) is more preferable.

Any compound may be used as the lithium salt without particular limitation as long as it is a compound capable of providing lithium ions used in lithium secondary batteries. To be specific, an anion of the lithium salt may be at least one selected from the group consisting of F⁻, Cl⁻, Br⁻, I⁻, NO₃⁻, N(CN)₂⁻, BF₄⁻, CF₃CF₂SO₃⁻, (CF₃SO₂)₂N⁻, (FSO₂)₂N⁻, CF₃CF₂(CF₃)₂CO⁻, (CF₃SO₂)₂CH⁻, (SF₅)₃C⁻, (CF₃SO₂)₃C⁻, CF₃(CF₂)₇SO₃⁻, CF₃CO₂⁻, CH₃CO₂⁻, SCN⁻, and (CF₃CF₂SO₂)₂N⁻, and as the lithium salt, LiPF₆, LiClO₄, LiAsF₆, LiBF₄, LiSbF₆, LiAl0₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, or LiB(C₂O₄)₂ may be used. The lithium salt may be preferably used in a concentration range of 0.1 M to 2.0 M. When the concentration of the lithium salt is included within the above range, the electrolyte has suitable conductivity and viscosity and may thus exhibit excellent performance, and lithium ions may effectively move.

In the electrolyte, in order to improve the lifespan properties of a battery, suppress the decrease in battery capacity, and improve the discharge capacity of the battery, one or more kinds of additives, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, and the like may be further included. In this case, the additive may be included in an amount of 0.1 wt% to 5 wt% with respect to a total weight of the electrolyte.

The lithium secondary battery including the positive electrode active material according to the present invention stably exhibits excellent capacity properties, output properties, and lifespan properties, and thus, are useful for portable devices such as a mobile phone, a notebook computer, and a digital camera, and in the field of electric cars such as a hybrid electric vehicle (HEV) and an electric vehicle (EV) .

The outer shape of the lithium secondary battery of the present invention is not particularly limited, and thus a cylindrical shape using a can, a prismatic shape, a pouch shape, or a coin shape, may be used.

The lithium secondary battery according to the present invention may be used in a battery cell which is used as a power source for a small-sized device, and may also be preferably used as a unit cell for a medium- and large-sized battery module including a plurality of battery cells.

Accordingly, a battery module including the lithium secondary battery as a unit cell, and a battery pack including the same are provided.

The battery module or the battery pack may be used as a power source of at least any one medium and large sized device of a power tool; electric cars including an electric vehicle (EV), a hybrid electric vehicle, and a plug-in hybrid electric vehicle (PHEV); or a power storage system.

### MODE FOR CARRYING OUT THE INVENTION

Hereinafter, examples of the present invention will be described in detail in such a manner that it may easily be performed by a person with ordinary skill in the art to which the present invention pertains. The present invention may, however, be embodied in many different forms, and is not limited to Examples set forth herein.

### Examples and Comparative Examples

### Example 1

A secondary particle-type positive electrode active material precursor (composition: Ni_{0.35}Mn_{0.65}(OH)₂) and LiOH were dry-mixed such that a molar ratio of (Ni+Mn):Li was 1:1.28 to prepare a mixture. The mixture was fired at 880 °C for 9 hours in an air atmosphere to prepare a lithium-rich manganese oxide (positive electrode active material).

### Examples 2 to 10

A positive electrode active material was prepared in the same manner as in Example 1, except that the molar ratio of (Ni+Mn):Li and the firing temperature were adjusted as shown in Table 1 below.

### Comparative examples 1 to 13

A positive electrode active material was prepared in the same manner as in Example 1, except that the molar ratio of (Ni+Mn):Li and the firing temperature were adjusted as shown in Table 1 below.

**[Table 1]**

| Item | Molar ratio of (Ni+Mn):Li | Firing temperature (°C) |
|---|---|---|
| Example 1 | 1.28 | 880 |
| Example 2 | 1.30 | 880 |
| Example 3 | 1.32 | 880 |
| Example 4 | 1.28 | 900 |
| Example 5 | 1.30 | 900 |
| Example 6 | 1.30 | 920 |
| Example 7 | 1.32 | 920 |
| Example 8 | 1.30 | 930 |
| Example 9 | 1.32 | 930 |
| Example 10 | 1.30 | 940 |
| Comparative Example 1 | 1.34 | 880 |
| Comparative Example 2 | 1.24 | 900 |
| Comparative Example 3 | 1.26 | 900 |
| Comparative Example 4 | 1.32 | 900 |
| Comparative Example 5 | 1.34 | 900 |
| Comparative Example 6 | 1.36 | 900 |
| Comparative Example 7 | 1.34 | 920 |
| Comparative Example 8 | 1.36 | 920 |
| Comparative Example 9 | 1.34 | 930 |
| Comparative Example 10 | 1.36 | 930 |
| Comparative Example 11 | 1.32 | 940 |
| Comparative Example 12 | 1.34 | 940 |
| Comparative Example 13 | 1.36 | 940 |

### Experimental Example

### Experimental Example 1: Determination of composition of lithium-rich manganese oxide

0.1 g of each lithium-rich manganese oxide prepared in Examples and Comparative Examples was taken, and then 1 ml of hydrochloric acid was added and heated to dissolve the lithium-rich manganese oxide. Thereafter, a small amount of hydrogen peroxide was added to promote a reaction, and the lithium-rich manganese oxide was completely dissolved to prepare a solution. Then, the solution diluted to a total volume of 10 mL with deionized water to prepare an analysis sample. Using an ICP device (Perkin Elmer, OPTIMA 7300DV), a weight ratio of constituent elements present in the analysis sample was measured, and composition of the lithium-rich manganese oxide and a Li/Me (lithium (Li) to total metals excluding lithium (Me)) molar ratio are shown in Table 2 below.

**[Table 2]**

| Item | Composition | Li/Me |
|---|---|---|
| Example 1 | Li_{1.130}Ni_{0.310}Mn_{0.575}O₂ | 1.28 |
| Example 2 | Li_{1.138}Ni_{0.308}Mn_{0.571}O₂ | 1.30 |
| Example 3 | Li_{1.147}Ni_{0.305}Mn_{0.567}O₂ | 1.32 |
| Example 4 | Li_{1.130}Ni_{0.310}Mn_{0.575}O₂ | 1.28 |
| Example 5 | Li_{1.138}Ni_{0.308}Mn_{0.571}O₂ | 1.30 |
| Example 6 | Li_{1.138}Ni_{0.308}Mn_{0.571}O₂ | 1.30 |
| Example 7 | Li_{1.147}Ni_{0.305}Mn_{0.567}O₂ | 1.32 |
| Example 8 | Li_{1.138}Ni_{0.308}Mn_{0.571}O₂ | 1.30 |
| Example 9 | Li_{1.147}Ni_{0.305}Mn_{0.567}O₂ | 1.32 |
| Example 10 | Li_{1.138}Ni_{0.308}Mn_{0.571}O₂ | 1.30 |
| Comparative Example 1 | Li_{1.156}Ni_{0.303}Mn_{0.562}O₂ | 1.34 |
| Comparative Example 2 | Li_{1.112}Ni_{0.315}Mn_{0.585}O₂ | 1.24 |
| Comparative Example 3 | Li_{1.121}Ni_{0.312}Mn_{0.580}O₂ | 1.26 |
| Comparative Example 4 | Li_{1.147}Ni_{0.305}Mn_{0.567}O₂ | 1.32 |
| Comparative Example 5 | Li_{1.156}Ni_{0.303}Mn_{0.562}O₂ | 1.34 |
| Comparative Example 6 | Li_{1.165}Ni_{0.300}Mn_{0.558}O₂ | 1.36 |
| Comparative Example 7 | Li_{1.156}Ni_{0.303}Mn_{0.562}O₂ | 1.34 |
| Comparative Example 8 | Li_{1.165}Ni_{0.300}Mn_{0.558}O₂ | 1.36 |
| Comparative Example 9 | Li_{1.156}Ni_{0.303}Mn_{0.562}O₂ | 1.34 |
| Comparative Example 10 | Li_{1.165}Ni_{0.300}Mn_{0.558}O₂ | 1.36 |
| Comparative Example 11 | Li_{1.147}Ni_{0.305}Mn_{0.567}O₂ | 1.32 |
| Comparative Example 12 | Li_{1.156}Ni_{0.303}Mn_{0.562}O₂ | 1.34 |
| Comparative Example 13 | Li_{1.165}Ni_{0.300}Mn_{0.558}O₂ | 1.36 |

Referring to Table 2, it is determined that the lithium-rich manganese oxides of Examples 1 to 10 satisfy the composition represented by Formula 1 described herein, and the molar ratio of lithium to total metal excluding lithium satisfies 1.28 to 1.32.

### Experimental Example 2: Determination of average particle size of lithium-rich manganese oxide

To determine an average particle size of each lithium-rich manganese oxide prepared in Examples 5 to 10 above, the particle size of lithium-rich manganese oxide was measured using PSA (Microtrac, S3500), and the results are shown in Table 3 below.

**[Table 3]**

| Item | Average particle size (D₅₀) (µm) |
|---|---|
| Example 5 | 9.53 |
| Example 6 | 9.52 |
| Example 7 | 9.56 |
| Example 8 | 9.53 |
| Example 9 | 9.57 |
| Example 10 | 9.53 |

Referring to Table 3, it is determined that the lithium-rich manganese oxides of Examples 5 to 10 have an average particle size of 9.50 µm to 9.60 µm.

### Experimental Example 3: Battery evaluation

### (Manufacturing of battery)

A positive electrode slurry was prepared by mixing 92.5 wt% of each of the positive electrode active materials prepared in Examples and Comparative Examples, 3 wt% of Super P as a conductive material, and 4.5 wt% of polyvinylidene fluoride (PVDF) as a binder in an N-methylpyrrolidone (NMP) solvent. The prepared positive electrode slurry was applied onto one surface of an aluminum current collector (thickness: 20 µm), dried at 130 °C, and then rolled to prepare a positive electrode.

A lithium metal electrode was used as a negative electrode, and an electrode assembly was prepared by disposing a porous polyethylene separator between the positive electrode and the negative electrode. The electrode assembly was placed inside a battery case and an electrolyte (additive: LiBF₄ 0.5%, FEC 3.0%) where 1 M LiPF₆ was dissolved in an organic solvent in which ethylene carbonate (EC) and ethyl methyl carbonate (EMC) were mixed in a volume ratio of 3:7 was injected to manufacture a coin-type half-cell.

### (Analysis of positive electrode active material)

The coin-type half-cells including the positive electrode active materials prepared in Examples and Comparative Examples were charged up to 4.65 V at a constant current of 0.1 C at 45 °C and then discharged up to 2.0 V at a constant current of 0.1 C and then a slope of a graph obtained by applying linear fitting to data in a voltage range of 4.40 to 4.65 V using a program of Origin in a specific capacity-voltage graph (X-axis: specific capacity (mAh/g), Y-axis: voltage (V)) obtained while performing an activation process (formation) is shown in Table 4 below. In addition, the charge and discharge capacities obtained under these conditions are shown in Table 4 below, and the efficiency of the activation process, defined as the percentage of the discharge capacity to the charge capacity under these conditions, is presented in Table 4 below.

For reference, the slope of the graph obtained through linear fitting is a value analyzed by performing linear regression analysis using weighted least squares in a program of Origin.

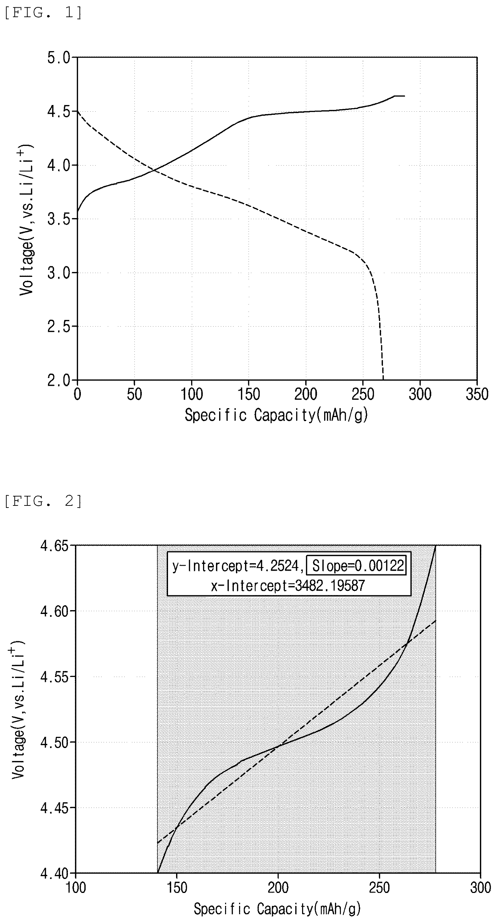

FIG. 1 is a graph of specific capacity-voltage (X-axis: specific capacity (mAh/g), Y-axis: voltage (V)) obtained when a battery including the positive electrode active material of Example 1 was evaluated as in Experimental Example 1, and FIG. 2 is a view showing a slope of a graph obtained by applying linear fitting to data in a voltage range of 4.40 to 4.65 V through a program of Origin, in the graph of FIG. 1.

### (Battery evaluation)

Batteries subjected to an activation process were charged up to 4.4 V at a constant current of 0.1 C at 25 °C, and then discharged up to 2.5 V at a constant current of 0.1 C to determine initial charge/discharge performance, and the charge/discharge process was performed by changing this process from 0.1 C to 0.33 C, and this cycle was considered one cycle. Based on this, a total of 30 cycles of charge and discharge were repeated to determine discharge capacity, and the charge and discharge capacities in one cycle and the percentage of the discharge capacity to the charge capacity under these conditions are shown in Table 4 below, and the percentage of the discharge capacity in 30 cycles to the discharge capacity in one cycle is shown in Table 4 below as capacity retention.

**[Table 4]**

| Item | Slope | Activation process | | | Charge capacity in one cycle (mAh/g) | Discharge capacity in one cycle (mAh/g) | Efficiency in one cycle (%) | Capacity retention rate (%) |
|---|---|---|---|---|---|---|---|---|
| | | Charge capacity (mAh/g) | Discharge capacity (mAh/g) | Efficiency (%) | | | | |
| Example 1 | 0.00122 | 285.8 | 267.5 | 93.6 | 207 | 195.5 | 94.4 | 96.6 |
| Example 2 | 0.00123 | 292.1 | 270.3 | 92.5 | 209.8 | 194.5 | 92.7 | 97.8 |
| Example 3 | 0.00119 | 297.8 | 272.3 | 91.4 | 209.2 | 191.1 | 91.3 | 98.1 |
| Example 4 | 0.00115 | 285.7 | 263.8 | 92.3 | 201.6 | 192.4 | 95.4 | 95.9 |
| Example 5 | 0.00122 | 295.9 | 272.9 | 92.2 | 211.1 | 194.4 | 92.1 | 97.5 |
| Example 6 | 0.00127 | 294.3 | 270.5 | 91.9 | 209.2 | 193.6 | 92.5 | 97.6 |
| Example 7 | 0.00118 | 302.9 | 275.3 | 90.9 | 210.8 | 192.3 | 91.2 | 97.6 |
| Example 8 | 0.00125 | 296.4 | 269.9 | 91.1 | 207.7 | 190.4 | 91.7 | 97.4 |
| Example 9 | 0.00116 | 303.1 | 274.5 | 90.6 | 209.7 | 190.2 | 90.7 | 97.5 |
| Example 10 | 0.00122 | 300.3 | 270.2 | 90.0 | 207.4 | 190.3 | 91.7 | 97.5 |
| Comparative Example 1 | 0.00113 | 322.1 | 272.9 | 84.7 | 207.7 | 188.9 | 90.9 | 98.5 |
| Comparative Example 2 | 0.00350 | 187.5 | 158 | 84.3 | 105.8 | 93.3 | 88.2 | 93.3 |
| Comparative Example 3 | 0.00193 | 232.9 | 192.1 | 82.5 | 136.2 | 125.6 | 92.2 | 93.0 |
| Comparative Example 4 | 0.00114 | 299.7 | 274.1 | 91.5 | 208.8 | 188.8 | 90.4 | 97.8 |
| Comparative Example 5 | 0.00105 | 308.7 | 274.6 | 89.0 | 205.4 | 183.4 | 89.3 | 97.8 |
| Comparative Example 6 | 0.00107 | 306.9 | 275.7 | 89.8 | 208.5 | 187.4 | 89.9 | 97.9 |
| Comparative Example 7 | 0.00106 | 308.9 | 276.0 | 89.3 | 208.0 | 186.4 | 89.6 | 97.6 |
| Comparative Example 8 | 0.00108 | 307.6 | 274.9 | 89.4 | 208.5 | 187.6 | 90.0 | 97.7 |
| Comparative Example 9 | 0.00111 | 305.9 | 276.4 | 90.4 | 209.1 | 188.8 | 90.3 | 97.8 |
| Comparative Example 10 | 0.00098 | 316.4 | 277.8 | 87.8 | 208.5 | 185.9 | 89.1 | 97.7 |
| Comparative Example 11 | 0.00109 | 304.2 | 273.5 | 89.9 | 208.9 | 189.9 | 90.9 | 97.6 |
| Comparative Example 12 | 0.00111 | 306.9 | 275.1 | 89.7 | 209.4 | 189.5 | 90.5 | 97.6 |
| Comparative Example 13 | 0.00098 | 315.3 | 275.7 | 87.4 | 206.5 | 184.0 | 89.1 | 98.7 |

Referring to Table 4, it is determined that in the positive electrode active materials of Examples, the slope obtained according to the positive electrode active material analysis method satisfies 0.00115 to 0.00150, and accordingly, batteries including the positive electrode active materials are superior in performances such as capacity and efficiency in the activation process, capacity and efficiency under 0.33 C-rate conditions, and capacity retention. In particular, it is determined that the discharge capacity of the batteries under 0.33 C-rate conditions is as high as 190 mAh/g or greater. In conclusion, it is seen that according to the method for analyzing the positive electrode active material according to the present invention, LMRO capacity characteristics may be predicted when using a slope obtained through the process of high-temperature activation (45 °C, 0.1 C-rate) of a lithium secondary battery, and thus the time for analyzing performance of the positive electrode active material may be reduced. In addition, in the positive electrode active material according to the present invention, it is seen that a lithium-rich manganese oxide is included, and in a specific capacity-voltage graph (X-axis: specific capacity (mAh/g), Y-axis: voltage (V)) obtained by activating a lithium secondary battery including the positive electrode active material at 45 °C with a 0.1 C-rate, a slope of the graph obtained by applying linear fitting to data in a voltage range of 4.40 to 4.65 V satisfies a specific range, and accordingly, batteries exhibit excellent performance, particularly excellent discharge capacity characteristics.

## Claims

1. A method for analyzing a positive electrode active material, the method comprising:
(S1) preparing a positive electrode active material comprising a lithium-rich manganese oxide having a layered structure comprising both a Li₂MnO₃ phase and a LiMO₂ phase (where M is an element comprising at least one selected from Ni and Mn), and manufacturing a lithium secondary battery comprising a positive electrode comprising a positive electrode active material layer comprising the positive electrode active material in an amount of at least 80 wt% with respect to a total weight of the positive electrode active material layer;
(S2) obtaining a specific capacity-voltage graph (X-axis: specific capacity (mAh/g), Y-axis: voltage (V)) obtained by activating the lithium secondary battery at 45 °C with a 0.1 C-rate; and
(S3) in the graph, applying linear fitting to data in a voltage range of 4.40 to 4.65 V to obtain a slope.

2. The method of claim 1, wherein the lithium-rich manganese oxide exhibits a Li/Me (lithium (Li) to total metals excluding lithium (Me)) molar ratio of greater than 1.00 and 2.00 or less.

3. The method of claim 1, wherein the lithium-rich manganese oxide exhibits a Li/Me (lithium (Li) to total metals excluding lithium (Me)) molar ratio of 1.24 to 1.36.

4. The method of claim 1, wherein the lithium-rich manganese oxide contains at least 50 mol% of Mn with respect to total metals excluding lithium.

5. The method of claim 1, wherein the lithium-rich manganese oxide has a composition represented by Formula 1 below:
[Formula 1] Li₁₊ₓNiₐMn_{b}M_{c}O₂
wherein, in Formula 1 above,
M is at least one selected from W, Al, B, Mo, Ti, Co, V, P, Mg, Fe, K, Ca, Na, Y, and Nb, and
0.10 ≤ x ≤ 0.20, 0 < a ≤ 0.50, 0.50 ≤ b < 1.0, and 0 ≤ c ≤ 0.10.

6. The method of claim 1, wherein the linear fitting involves performing linear regression analysis using weighted least squares in a program of Origin.

7. A positive electrode active material comprising a lithium-rich manganese oxide having a layered structure comprising both a Li₂MnO₃ phase and a LiMO₂ phase (where M is an element comprising at least one selected from Ni and Mn),
wherein in a specific capacity-voltage graph (X-axis: specific capacity (mAh/g), Y-axis: voltage (V)) obtained by activating a lithium secondary battery comprising a positive electrode comprising a positive electrode active material layer comprising the positive electrode active material in an amount of at least 80 wt% with respect to a total weight of the positive electrode active material layer at 45 °C with a 0.1 C-rate, a slope of the graph obtained by applying linear fitting to data in a voltage range of 4.40 to 4.65 V is 0.00115 to 0.00150.

8. The positive electrode active material of claim 7, wherein the lithium-rich manganese oxide exhibits a Li/Me (lithium (Li) to total metals excluding lithium (Me)) molar ratio of greater than 1.00 and 2.00 or less.

9. The positive electrode active material of claim 7, wherein the lithium-rich manganese oxide exhibits a Li/Me (lithium (Li) to total metals excluding lithium (Me)) molar ratio of 1.24 to 1.36.

10. The positive electrode active material of claim 7, wherein the lithium-rich manganese oxide contains at least 50 mol% of Mn with respect to total metals excluding lithium.

11. The positive electrode active material of claim 7, wherein the lithium-rich manganese oxide has a composition represented by Formula 1 below:
[Formula 1] Li₁₊ₓNiₐMn_{b}M_{c}O₂
wherein, in Formula 1 above,
M is at least one selected from W, Al, B, Mo, Ti, Co, V, P, Mg, Fe, K, Ca, Na, Y, and Nb, and
0.10 ≤ x ≤ 0.20, 0 < a ≤ 0.50, 0.50 ≤ b < 1.0, and 0 ≤ c ≤ 0.10.

12. The positive electrode active material of claim 7, wherein the lithium-rich manganese oxide has a tap density of 1.5 g/cm³ to 2.5 g/cm³.

13. The positive electrode active material of claim 7, wherein the lithium-rich manganese oxide has an average particle size (D₅₀) of 2.0 µm to 20.0 µm.

14. A positive electrode comprising the positive electrode active material according to any one of claims 7 to 13.

15. A lithium secondary battery comprising the positive electrode according to claim 14.
